# EUROPEAN PATENT APPLICATION

(11) **EP 4 175 107 A1**
(43) Date of publication of application: **03.05.2023**
(21) Application number: 21210811.2
(22) Date of filing: 26.11.2021
(51) Int. Cl.: H02J 7/00, G01R 31/392, G01R 31/389

(54) **METHOD, APPARTUS, STORAGE MEDIUM AND SYSTEM FOR CONTROLLING POWER CONVERTER**

(30) Priority: 27.10.2021 CN 202111255352
(71) Applicant: Hitachi Energy Switzerland AG, 5400 Baden (CH)
(72) Inventor: HUANG, Xing, Beijing, 100024 (CN); YANG, XiaoBo, Beijing, 100015 (CN); TUCKEY, Andrew, Livingstone, 0837 (AU)
(74) Representative: Vossius & Partner Patentanwälte Rechtsanwälte mbB

(57) **Abstract**

A method for controlling at least one power converter is disclosed. The method includes generating at least one electrochemical impedance spectra (EIS) reference signal, the at least one EIS reference signal each having a frequency selected for EIS; superimposing the at least one EIS reference signal respectively on at least one control reference signal to produce at least one superimposed reference signal; controlling the at least one power converter respectively based on the at least one superimposed reference signal to cause respectively charging/discharging at least one battery module; acquiring at least one response signal produced respectively by the at least one battery module; and calculating at least one EIS respectively for the at least one battery module respectively based on the at least one superimposed reference signal and the at least one response signal.

## Description

### TECHNICAL FIELD

The present disclosure relates to the fields of power conversion, and more specifically, to a method, an apparatus, a computer readable storage medium and a system for controlling at least one power converter.

### BACKGROUND

In recent years, Electrochemical Impedance Spectra (EIS) has been widely used to monitor the health condition of battery by virtue of its high accuracy. EIS is a non-destructive measurement, which can provide not only the detailed kinetic information inside the battery, but can also be used to monitor the changes in properties of the battery under different usage or storage conditions.

In order to know about the EIS information, however, a specially designed equipment is usually required. Since the specially designed equipment is used for EIS only, the health condition of battery can only be tested by an offline monitoring process. So far, an online EIS monitoring process of the health condition of battery has not been developed, which limits the application of EIS, especially in the battery energy storage system (BESS) having a power converter.

### SUMMARY

The present disclosure provides a method, an apparatus, a computer readable storage medium and a system for controlling at least one power converter.

According to an aspect of the present disclosure, a method for controlling at least one power converter is disclosed. The method includes generating at least one electrochemical impedance spectra (EIS) reference signal, the at least one EIS reference signal each having a frequency selected for EIS; superimposing the at least one EIS reference signal respectively on at least one control reference signal to produce at least one superimposed reference signal; controlling the at least one power converter respectively based on the at least one superimposed reference signal to cause respectively charging/discharging at least one battery module; acquiring at least one response signal produced respectively by the at least one battery module; and calculating at least one EIS respectively for the at least one battery module respectively based on the at least one superimposed reference signal and the at least one response signal.

According to a further aspect of the present disclosure, an embodiment of the present disclosure discloses an apparatus for controlling at least one power converter. The apparatus includes means for performing the method as described above.

According to a further aspect of the present disclosure, an embodiment of the present disclosure discloses a computer readable storage medium. The computer readable storage medium includes instructions which, when executed by a processor, cause the processor to perform the method as described above.

According to a further aspect of the present disclosure, an embodiment of the present disclosure discloses a system for controlling at least one power converter. The system includes the at least one power converter; at least one battery module; and a controlling apparatus comprising means for performing the method as described above.

According to the present disclosure, an online EIS monitoring process in the BESS can be achieved without specially designed equipment for the EIS, and thus the cost for performing the EIS can be reduced.

It should be understood that the content described in this section is not intended to identify critical or important features of the embodiments of the present disclosure, and is not used to limit the scope of the present disclosure either. Other features of the present disclosure will be easily understood through the following specification.

### BRIEF DESCRIPTION OF THE DRAWINGS

The drawings exemplarily show embodiments and form a part of the specification, and are used to illustrate example implementations of the embodiments together with a written description of the specification. The embodiments shown are merely for illustrative purposes and do not limit the scope of the claims. Throughout the drawings, like reference signs denote like but not necessarily identical elements.
Fig. 1 is a flowchart showing a method for controlling at least one power converter according to one or more examples of the present disclosure.
Figs. 2A and 2B are schematic diagrams showing the method for controlling a DC/AC power converter according to one or more examples of the present disclosure.
Figs. 3A and 3B are schematic diagrams showing the method for controlling a DC/DC power converter according to one or more examples of the present disclosure.
Fig. 4 is a schematic diagram showing the method for controlling multiple DC/AC power converters according to one or more examples of the present disclosure.
Fig. 5 is a schematic diagram showing the method for controlling multiple DC/DC power converters according to one or more examples of the present disclosure.
Fig. 6 is a structural block diagram showing an apparatus for controlling at least one power converter according to one or more examples of the present disclosure.
Fig. 7 is a structural block diagram showing an example system that can be used to implement one or more examples of the present disclosure.

### DETAILED DESCRIPTION OF THE EMBODIMENTS

The present disclosure will be further described in detail below with reference to the drawings and embodiments. It can be understood that embodiments described herein are used merely to explain a related disclosure, rather than limit the disclosure. It should be additionally noted that, for ease of description, only parts related to the related disclosure are shown in the drawings.

It should be noted that the embodiments in the present disclosure and features in the embodiments can be combined with each other without conflict. If the number of elements is not specifically defined, there may be one or more elements, unless otherwise expressly indicated in the context. In addition, numbers of steps or functional modules used in the present disclosure are used merely to identify the steps or functional modules, rather than limit either a sequence of performing the steps or a connection relationship between the functional modules. As used herein, the term "and/or" includes any and all combinations of one or more of the associated listed items. The term "based on" is to be construed as "based at least in part on".

In the related art, EIS is implemented through an offline monitoring process via a specially designed equipment for the EIS, which would bring both cost and design issues when it is applied to the battery energy storage system (BESS) having a power converter.

Aiming at this problem, the present disclosure provides a method for controlling at least one power converter to achieve an online EIS monitoring process in the BESS without specially designed equipment for the EIS.

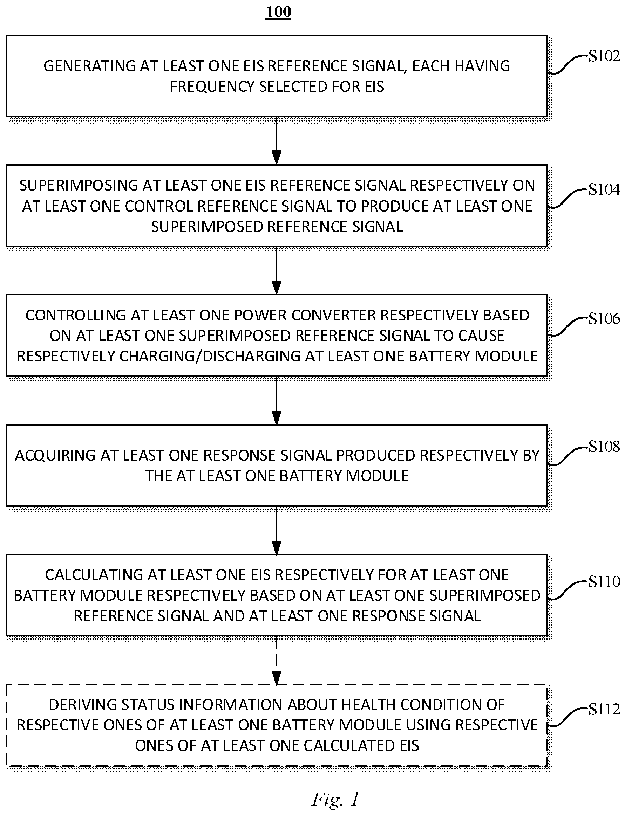

Fig. 1 is a flowchart showing a method 100 for controlling at least one power converter according to one or more examples of the present disclosure. As shown in Fig. 1, the method 100 may include steps S102 to S110, which will be described in further detail hereinafter.

In the step S102, at least one electrochemical impedance spectra (EIS) reference signal may be generated, and the at least one EIS reference signal each may have a frequency selected for EIS.

The EIS reference signal may have a certain waveform, for example, a sine wave, a square wave, a triangular wave and the like. The waveform for the EIS reference signal may be determined based on the actual applications, which may not be limited to the above examples.

The frequency selected for EIS may be determined based on the property to be monitored or the property of interest for the battery. Since the impedance measured through EIS is closely related to various properties of battery, such as the ohmic resistance of the electrolyte, the solid electrolyte interphase (SEI) capacitance, the electron transfer rate and the diffusion processes of species in the insertion material of battery, the frequency selected for EIS may correspond to the property of interest based on the actual application, which may not be limited to the above examples. Each of the properties may correspond to a certain frequency or frequency range, from approximately several µHz to several MHz. For example, to monitor the ohmic resistance of the electrolyte, a frequency selected from the ultrahigh frequency range may be adopted.

In some embodiments, the generation of the at least one EIS reference signal may include pulse-width modulating the EIS reference signal. In this way, various frequencies of interest can be obtained through various modulations to achieve the online EIS monitoring method. The pulse-width modulation may be achieved by a pulse-width modulation (PWM) modulator, or may be performed on a software/firmware (e.g., via FPGA (field programmable gate array))/hardware (e.g., via DSP (digital signal processor)) basis.

In some embodiments, the at least one power converter each may include a power electronic component comprising silicon carbide (SiC). The power electronic component may include a switching device. The SiC switching device may switch at much higher frequencies than the Si-based switching devices. Owing to the higher switching frequencies, the SiC switching device may achieve a higher frequency bandwidth than the Si-based switching devices. The SiC switching device may also bring cost effectiveness due to a reduction in the filter size/cost. In addition, the higher frequency bandwidth may help to increase the accuracy on the health condition monitoring and to realize the health condition monitoring of more elements in a battery.

In the step S104, the at least one EIS reference signal may be superimposed respectively on at least one control reference signal to produce at least one superimposed reference signal.

In some embodiments, the at least one control reference signal may include, but is not limited to, an inertia reference signal, a fast frequency support reference signal, a frequency control ancillary service reference signal, a network support reference signal, and/or a charging/discharging reference signal and the like. In this way, the EIS reference signal can be flexibly superimposed to any of the various reference signals to achieve the online EIS monitoring method according to the present disclosure.

In the step S106, the at least one power converter may be controlled respectively based on the at least one superimposed reference signal to cause respectively charging/discharging at least one battery module.

In the step S108, at least one response signal produced respectively by the at least one battery module may be acquired.

The response signal may include a voltage of the battery module, when the power converter is controlling a charging current of the battery module. Alternatively, the response signal may include a current of the battery module, when the power converter is controlling a charging voltage of the battery module.

For example, the voltage or the current of the battery module may be measured or obtained by using a voltage/current sensor and an AD (Analog/Digital) or ADC (Analog to Digital Converter) module of the BMS. The voltage or the current of the battery module may also be measured or obtained by an additional piece of measurement equipment, which may be separate from the BMS.

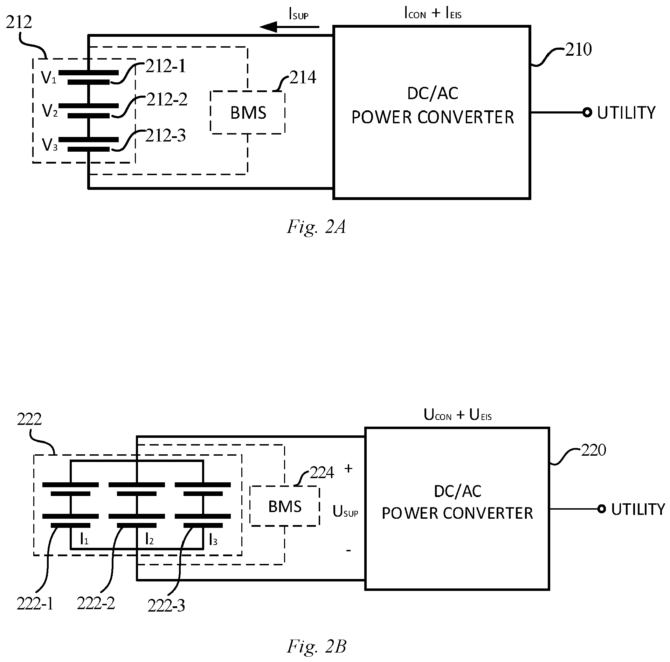

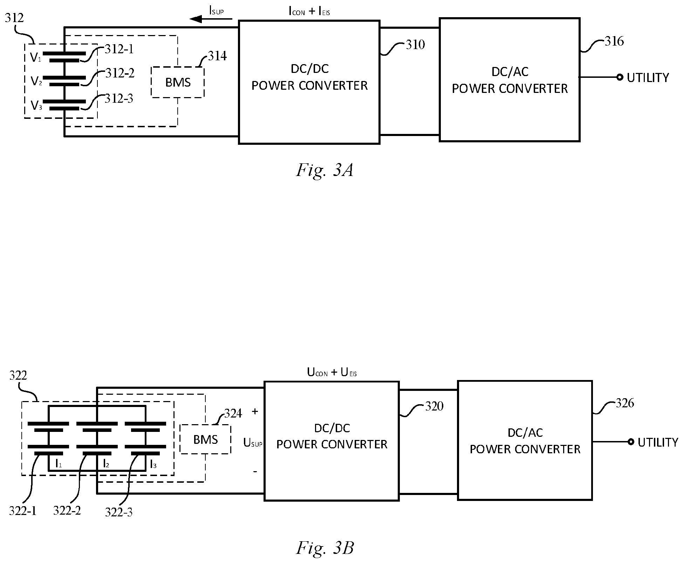

In some embodiments, the charge/discharge of the battery module based on the superimposed reference signal may include controlling a charging/discharging current. Accordingly, the at least one battery module each may include at least one battery cell connected in series. The at least one response signal each may include a voltage signal generated across respective ones of the at least one battery cell. Hereinafter, Figs. 2A and 3A will be described in connection with such embodiments.

In some embodiments, the charge/discharge of the battery module based on the superimposed reference signal may include controlling a charging/discharging voltage across the at least one battery string. Accordingly, the at least one battery module each comprises at least one battery string connected in parallel, and each battery string may include at least one battery cell. The at least one response signal each may comprise a current signal output from a respective one of the at least one battery string. Hereinafter, Figs. 2B and 3B will be described in connection with such embodiments.

Setting the control current or voltage based on the structure of the battery module can enable the adaption of the superimposed reference signal to the battery module, so that the EIS reference signal used for the online EIS monitoring can be injected via the charging/discharging of the battery module.

In some embodiments, in the case that the number of the at least one battery module is an integral multiple of two (e.g., two, four, six and so on), the EIS reference signals for every two power converters may be spaced with a phase shift of 180 degrees (i.e., *π*)*.*

In some embodiments, in the case that the number of the at least one battery module is *N* that is an odd number being above two (e.g., three, five and so on), the corresponding EIS reference signals may be spaced with a phase shift of 360 degrees divided by N (i.e., *2π*/*N*).

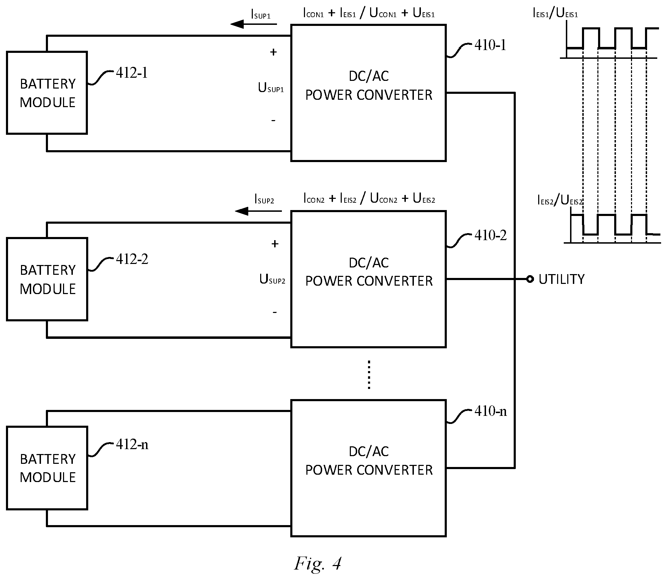

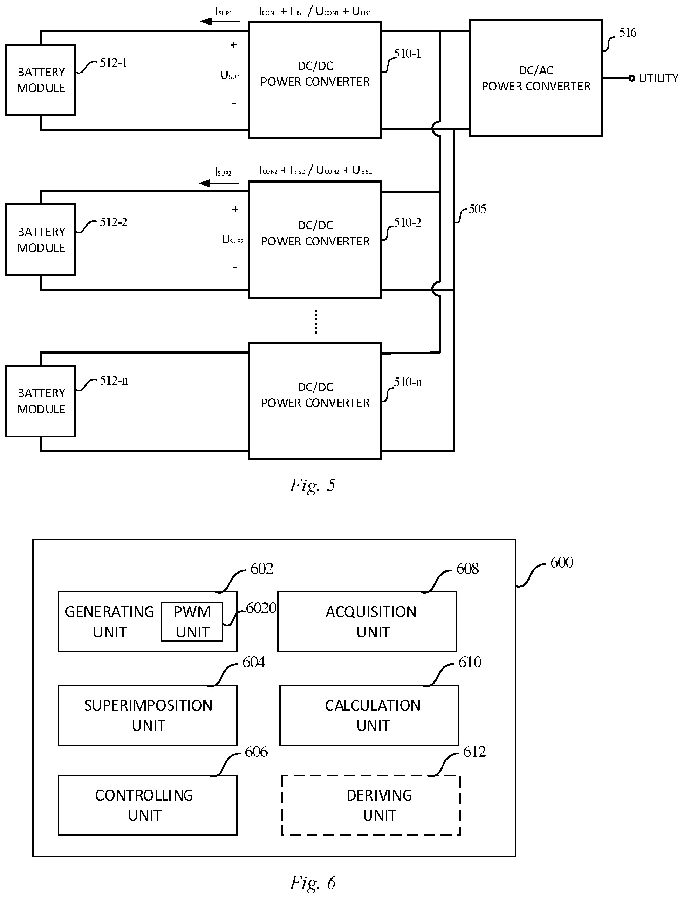

In this way, an interleaved signal having a compensated current/voltage pulse may be generated through the phase shift, so that a power quality issue due to the power fluctuation caused by the injection of the EIS reference signal can be mitigated or removed. Hereinafter, Figs. 4 and 5 will be described in connection with these embodiments.

In some embodiments, the acquiring of the at least one response signal may be performed by a battery management system (BMS). The BMS may be communicatively coupled to the at least one battery module so that the at least one response signal produced by the at least one battery module may be acquired. The adoption of the inherent BMS within the BESS can bring easy implementation of the online EIS monitoring method without introducing additional signal detecting device.

In the step S110, at least one EIS respectively for the at least one battery module may be calculated respectively based on the at least one superimposed reference signal and the at least one response signal.

In an example, in the case that the at least one battery module each includes at least one battery cell connected in series, the impedance of the respective ones of the at least one battery cell may be obtained through dividing the at least one response signal (i.e., a voltage signal) by the superimposed reference signal (i.e., a current signal) respectively.

In an example, in the case the at least one battery module each includes at least one battery string connected in parallel, the impedance of the respective ones of the at least one battery string may be obtained through dividing the superimposed reference signal (i.e., a voltage signal) by the at least one response signal (i.e., a current signal) respectively.

In some embodiments, after the step S110, the method 100 may further include a step S112 at which status information about a health condition of the respective ones of the at least one battery module may be derived using respective ones of the at least one calculated EIS. The health condition may include state of charge (SOC) and/or state of health (SOH) of the battery and the like.

According to the present disclosure, a method for controlling at least one power converter to achieve an online EIS monitoring process in the BESS is provided, without introducing specially designed equipment for the EIS. Through the occasion for the charging/discharging of the battery module, the EIS reference signal used for the online EIS monitoring process is injected from the power converter into the battery module, so that the health condition of the battery module can be monitored in real time. In this way, the online EIS monitoring process can be integrated to the power converter or the power converter system (PCS) of the BESS with both of the cost and design burden reduced.

Figs. 2A and 2B are schematic diagrams showing the method for controlling a DC/AC power converter according to one or more examples of the present disclosure. Except that the internal structures of the battery modules differ from each other and thus the reference signals (i.e., the EIS reference signal, the control reference signal and the response signal) are represented by either a current signal or a voltage signal, the principle of the method for controlling the power converter are substantially the same.

As shown in Fig. 2A, a DC/AC power converter 210 may be configured to deliver a superimposed reference signal Iₛᵤₚ, which includes an EIS reference signal I_{EIS} superimposed on a control reference signal I_{con}, to a battery module 212 to charge/discharge the battery module 212. The power converter 210 may be coupled to the utility side (e.g., the power grid).

As described above, the EIS reference signal I_{EIS} may be generated in advance and then superimposed on the control reference signal I_{con}. The EIS reference signal I_{EIS} may have a certain wave form (e.g., a sine wave, a square wave, a triangular wave, etc.) and a frequency selected for EIS. The frequency selected for EIS may be determined based on the property to be monitored for the battery (e.g., the ohmic resistance of the electrolyte, the SEI capacitance, the electron transfer rate, the diffusion processes of species in the insertion material of battery, etc.). The control reference signal I_{con} may include, e.g., an inertia reference signal, a fast frequency support reference signal, a frequency control ancillary service reference signal, a network support reference signal, and/or a charging/discharging reference signal.

The battery module 212 may include a battery string consisted of a first to third battery cells 212-1 to 212-3 connected in series. Although three battery cells are shown for purpose of illustration, less or more battery cells are possible based on the actual applications.

As a response to the injected superimposed reference signal Iₛᵤₚ, which contains the predetermined EIS reference signal I_{EIS} having the selected frequency for EIS to monitor the health condition of the battery module, the first to third battery cells 212-1 to 212-3 may generate the respective response signals, i.e., response signals V₁ to V₃. Each of the response signals V₁ to V₃ may represent a voltage signal generated across the battery cell.

According to an embodiment, the response signals V₁ to V₃ may be acquired by a battery management system (BMS) 214, which is communicatively coupled to the first to third battery cells 212-1 to 212-3. For example, the BMS 214 may include three sub management units corresponding to the first to third battery cells 212-1 to 212-3, respectively, and each sub management unit may acquire the respective one of the response signals V₁ to V₃.

Alternatively, the response signals V₁ to V₃ may be acquired by an additional detecting means that is communicatively coupled to the first to third battery cells 212-1 to 212-3. In the case as shown in Fig. 2A, the detecting means may include three voltage detectors each coupled to a respective one of the first to third battery cells 212-1 to 212-3 in parallel to detect the voltage (i.e., the response signals V₁ to V₃) generated across the battery cell.

Subsequently, the impedance of each of the first to third battery cells 212-1 to 212-3 may be calculated based on the superimposed reference signal Iₛᵤₚ and each of the response signals V₁ to V₃, e.g., via dividing each of the response signals V₁ to V₃ by the superimposed reference signal Iₛᵤₚ.

Accordingly, the health conditions of the first to third battery cells 212-1 to 212-3 may be derived from the calculated EIS. As an example, a threshold for determining the health condition (e.g., an impedance threshold for a property of interest of the battery cell) may be preset so as to be compared with the calculated impedance to determine the health condition of the battery cell.

Fig. 2B illustrates a method for controlling the DC/AC power converter that is similar to that of Fig. 2A. Nevertheless, as shown in Fig. 2B, a DC/AC power converter 220 may be configured to deliver a superimposed reference signal Uₛᵤₚ, which includes an EIS reference signal U_{EIS} superimposed on a control reference signal U_{con}, to a battery module 222 to charge/discharge the battery module 222. In other words, the reference signals are voltage signals instead of current signals. The power converter 220 may be coupled to the utility side (e.g., the power grid).

Similarly, the EIS reference signal U_{EIS} may be generated in advance and then superimposed on the control reference signal U_{con}. The EIS reference signal U_{EIS} may have a certain wave form (e.g., a sine wave, a square wave, a triangular wave, etc.) and a frequency selected for EIS. The frequency selected for EIS may be determined based on the property to be monitored for the battery (e.g., the ohmic resistance of the electrolyte, the SEI capacitance, the electron transfer rate, the diffusion processes of species in the insertion material of battery, etc.). The control reference signal U_{con} may include, e.g., an inertia reference signal, a fast frequency support reference signal, a frequency control ancillary service reference signal, a network support reference signal, and/or a charging/discharging reference signal.

The battery module 222 may include three battery strings 222-1 to 222-3 connected in parallel, each including two battery cells. Although three battery strings and two battery cells in each string are shown for purpose of illustration, less or more battery strings and/or battery cells are possible based on the actual applications.

As a response to the injected superimposed reference signal Uₛᵤₚ, which contains the predetermined EIS reference signal U_{EIS} having the selected frequency for EIS to monitor the health condition of the battery module, the first to third battery strings 222-1 to 222-3 may generate the respective response signals, i.e., response signals I₁ to I₃. Each of the response signals I₁ to I₃ may represent a current signal output from the battery string.

According to an embodiment, the response signals I₁ to I₃ may be acquired by a battery management system (BMS) 224, which is communicatively coupled to the first to third battery strings 222-1 to 222-3. For example, the BMS 224 may include three sub management units corresponding to the first to third battery strings 222-1 to 222-3, respectively, and each sub management unit may acquire a respective one of the response signals I₁ to I₃.

Alternatively, the response signals I₁ to I₃ may be acquired by an additional detecting means that is communicatively coupled to the first to third battery strings 222-1 to 222-3. In the case as shown in Fig. 2B, the detecting means may include three current detectors each coupled to a respective one of the first to third battery strings 222-1 to 222-3 in series to detect the current signal output from the battery string.

Subsequently, the impedance of each of the first to third battery strings 222-1 to 222-3 may be calculated based on the superimposed reference signal Uₛᵤₚ and each of the response signals I₁ to I₃, e.g., via dividing the superimposed reference signal Uₛᵤₚ by each of the response signals I₁ to I₃.

Accordingly, the health conditions of the first to third battery strings 222-1 to 222-3 may be derived from the calculated EIS. As an example, a threshold for determining the health condition (e.g., an impedance threshold for a property of interest of the battery string) may be preset so as to be compared with the calculated impedance to determine the health condition of the battery string.

Figs. 3A and 3B are schematic diagrams showing the method for controlling a DC/DC power converter according to one or more examples of the present disclosure. Except for the type of the power converter, the principle of the method for controlling the power converter is substantially the same as that of Figs. 2A and 2B, and thus the details as to the same features are omitted here.

As shown in Fig. 3A, a DC/DC power converter 310 may be configured to deliver a superimposed reference signal Iₛᵤₚ, which includes an EIS reference signal I_{EIS} superimposed on a control reference signal I_{con}, to a battery module 312 to charge/discharge the battery module 312. The DC/DC power converter 310 may be coupled to the utility side (e.g., the power grid) via a DC/AC power converter 316.

The operation for acquiring response signals V₁ to V₃ of first to third battery cells 312-1 to 312-3 in the battery module 312 and a function of a BMS 314 (if any) are substantially the same as those of Fig. 2A. Accordingly, the impedance of each of the first to third battery cells 312-1 to 312-3 may be calculated based on the superimposed reference signal Iₛᵤₚ and each of the response signals V₁ to V₃, e.g., via dividing each of the response signals V₁ to V₃ by the superimposed reference signal Iₛᵤₚ. Then, the health conditions of the first to third battery cells 312-1 to 312-3 may be derived from the calculated EIS.

As shown in Fig. 3B, a DC/DC power converter 320 may be configured to deliver a superimposed reference signal Uₛᵤₚ, which includes an EIS reference signal U_{EIS} superimposed on a control reference signal U_{con}, to a battery module 322 to charge/discharge the battery module 322. The DC/DC power converter 320 may be coupled to the utility side (e.g., the power grid) via a DC/AC power converter 326.

The operation for acquiring response signals I₁ to I₃ of first to third battery strings 322-1 to 322-3 in the battery module 322 and a function of a BMS 324 (if any) are substantially the same as those of Fig. 2B. Accordingly, the impedance of each of the first to third battery strings 322-1 to 322-3 may be calculated based on the superimposed reference signal Uₛᵤₚ and each of the response signals I₁ to I₃, e.g., via dividing the superimposed reference signal Uₛᵤₚ by each of the response signals I₁ to I₃. Then, the health conditions of the first to third battery strings 322-1 to 322-3 may be derived from the calculated EIS.

Fig. 4 is a schematic diagram showing the method for controlling multiple DC/AC power converters according to one or more examples of the present disclosure.

Due to the fact that the EIS reference signal is to be externally injected to the power grid while the online EIS monitoring method is implemented, which may result in a power quality issue, the present disclosure further provides improved EIS measurement by creating an interleaved current/voltage to mitigate or remove the power quality issue during the implementation of the online EIS monitoring method.

As shown in Fig. 4, multiple DC/AC power converters 410-1 to 410-n (where n is a natural number that is greater than or equal to two) may be coupled in parallel to the utility side (e.g., the power grid).

Each of the DC/AC power converters 410-1 to 410-n may be configured to deliver a superimposed reference signal Iₛᵤₚ (e.g., Iₛᵤₚ₁ and Iₛᵤₚ₂ as shown), which includes an EIS reference signal I_{EIS} (e.g., I_{EIS1} and I_{EIS2} as shown) superimposed on a control reference signal I_{con} (e.g., I_{con1} and I_{con2} as shown), to a respective one of battery modules 412-1 to 412-n to charge/discharge the battery modules 412-1 to 412-n. Each of the battery modules 412-1 to 412-n may be configured in a same manner as the battery module 212 as illustrated in Fig. 2A. Thus, the detailed structure inside each of the battery modules 412-1 to 412-n is omitted here.

Specifically, the power converter 410-1 may be configured to deliver a superimposed reference signal Iₛᵤₚ₁, which includes an EIS reference signal I_{EIS1} superimposed on a control reference signal I_{con1}, to a battery module 412-1 to charge/discharge the battery module 412-1. Each of the remaining power converters 410-2 to 412-n may be configured in a same manner as the power converter 410-1, except that phases of the EIS reference signals I_{EIS1} to I_{EISn} are adjusted so as to create the interleaved current.

As described above, the additional injection of the harmonic current/voltage for EIS would cause power fluctuation. This power fluctuation may have disadvantages in affecting the DC capacitor life of the converter and at the same time affecting the utility as well. To this end, multiple power converters may be grouped to address this issue.

According to an embodiment, two, four, six etc. power converters may be grouped together. That is, the number of the power converters (and accordingly, the number of the corresponding battery modules) may be an integer multiple of two. In this case, the EIS reference signals for every two power converters may be spaced with a phase shift of 180 degrees (i.e., *π*). For example, in the case the number of the power converters is two, that is, power converters 410-1 and 410-2, the corresponding EIS reference signals I_{EIS1} and I_{EIS2} may be inverted in phase, as shown in Fig. 4.

According to an embodiment, the number of the power converters (and accordingly, the number of the corresponding battery modules) may be N that is an odd number being above two. In this case, the corresponding EIS reference signals may be spaced with a phase shift of 360 degrees divided by *N* (i.e., *2π*/*N*). For example, in the case the number of the power converters is three, that is, power converters 410-1, 410-2 and 410-3 (when *n*=3), the corresponding EIS reference signals I_{EIS1}, I_{EIS2} and I_{EIS3} may be spaced with a phase shift of 120 degrees.

As such, the interleaved current with a compensated current pulse can be created for limiting the harmonic current to address the power quality issue, since the harmonic current caused by each individual power converter can be compensated by other power converters in the same group. Therefore, the DC capacitor life of converter can be extended and the harmonic currents at the utility side can be limited.

The above embodiment of creating the interleaved current may refer to the battery modules 412-1 to 412-n each having at least one battery cell connected in series, which is similar to the embodiment as shown in Fig. 2A. Accordingly, the operation for acquiring response signals of the at least one battery cell in each of the battery modules and a function of a BMS (if any) are substantially the same as those of Fig. 2A.

Thus, the impedance of each of the at least one battery cell in each of the battery modules may be calculated based on the respective superimposed reference signal (e.g., Iₛᵤₚ₁, Iₛᵤₚ₂ and so on) and the respective response signals of the battery cells. Then, the health condition of the at least one battery cell in each of the battery modules may be derived from the calculated EIS.

Alternatively, the interleaved current may be replaced with an interleaved voltage in view of the internal structure of the battery modules 412-1 to 412-n. That is, each of the battery modules 412-1 to 412-n may include at least one battery string connected in parallel, which is similar to the embodiment as shown in Fig. 2B. Accordingly, the operation for acquiring response signals of the at least one battery string in each of the battery modules and a function of a BMS (if any) are substantially the same as those of Fig. 2B.

Thus, the impedance of each of the at least one battery string may be calculated based on the respective superimposed reference signal (e.g., Uₛᵤₚ₁, Uₛᵤₚ₂ and so on) and the respective response signals of the battery strings. Then, the health condition of the at least one battery string in each of the battery modules may be derived from the calculated EIS.

Fig. 5 is a schematic diagram showing the method for controlling multiple DC/DC power converters according to one or more examples of the present disclosure.

As shown in Fig. 5, multiple DC/DC power converters 510-1 to 510-n (where *n* is a natural number that is greater than or equal to two) may be coupled in parallel to a DC bus 505. The DC bus 505 is couped to the utility side (e.g., the power grid) via a DC/AC power converter 516.

In this embodiment, except that the type of the power converter is modified as the DC/DC power converter, the principle of the method for controlling the multiple power converters is substantially the same as that of Fig. 4, and thus the details as to the same features are omitted here.

Fig. 6 is a structural block diagram showing an apparatus 600 for controlling at least one power converter according to one or more examples of the present disclosure.

As shown in Fig. 6, the apparatus 600 may include a generating unit 602 configured to generate at least one EIS reference signal for EIS, the at least one EIS reference signal each having a frequency selected for EIS; a superimposition unit 604 configured to superimpose the at least one EIS reference signal respectively on at least one control reference signal to produce at least one superimposed reference signal; a controlling unit 606 configured to control the at least one power converter respectively based on the at least one superimposed reference signal to cause respectively charging/discharging at least one battery module; an acquisition unit 608 configured to acquire at least one response signal produced respectively by the at least one battery module; and a calculation unit 610 configured to calculate at least one EIS respectively for the at least one battery module respectively based on the at least one EIS reference signal and the at least one response signal.

The function of each of the above-mentioned units 602 to 610 may correspond to the steps S 102 to S110 as illustrated in Fig. 1, and thus the similar details are omitted here.

In some embodiments, the generating unit 602 may further include a pulse-width modulating (PWM) unit 6020 configured to pulse-width modulate the EIS reference signal.

In some embodiments, the apparatus 600 may further include a deriving unit 612 configured to derive status information about a health condition of the respective ones of the at least one battery module using respective ones of the at least one calculated EIS. The function of the deriving unit 612 may correspond the steps S112 as illustrated in Fig. 1, and thus the similar details are omitted here.

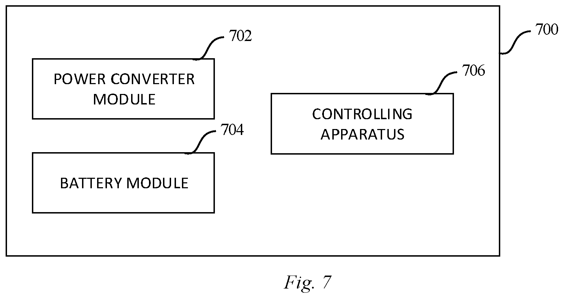

Fig. 7 is a structural block diagram showing an example system 700 that can be used to implement one or more examples of the present disclosure.

As illustrated in Fig. 7, the system 700 may include a power converter module 702 and a battery module 704. The power converter module 702 may include at least one power converter, and accordingly the battery module 704 may include at least one battery module corresponding to the at least one power converter.

The system 700 may further include a controlling apparatus 706 for controlling the at least one power converter. In an embodiment, the controlling apparatus 706 may include means for performing the method as described above, e.g., steps S102 to S112 as described in Fig. 1. In an embodiment, the apparatus 706 may be implemented similarly as the apparatus 600 as described in Fig. 6, and thus the similar details are omitted here.

According to the present disclosure, a computer readable storage medium is further provided, which includes instructions which, when executed by a processor, cause the processor to perform the method as described above.

According to the present disclosure, a computer program product is further provided, which, when executed by a processor, implements the method as described above.

The flowcharts and block diagrams in the accompanying drawings illustrate the possibly implemented architecture, functions, and operations of the system, method, and computer program product according to various embodiments of the present disclosure. In this regard, each block in the flowchart or block diagram may represent a module, program segment, or part of code, and the module, program segment, or part of code contains one or more executable instructions for implementing the logical functions. It should also be noted that, in some alternative implementations, the functions marked in the blocks may also occur in an order different from that marked in the accompanying drawings. For example, two blocks shown in succession can actually be performed substantially in parallel, or they can sometimes be performed in the reverse order, depending on the functions involved. It should also be noted that each block in the block diagram and/or the flowchart, and a combination of the blocks in the block diagram and/or the flowchart may be implemented by a dedicated hardware-based system that executes functions or operations, or may be implemented by a combination of dedicated hardware and computer instructions.

The related units/modules described in the embodiments of the present disclosure may be implemented by means of software, or may be implemented by means of hardware. The described modules may also be arranged in the processor, which for example may be described as: a processor, comprising a generating module, a superimposition module, a controlling module, an acquisition module and a calculation module. Names of these modules do not constitute a limitation on the modules themselves under certain circumstances.

The foregoing descriptions are merely preferred embodiments of the present disclosure and explanations of the applied technical principles. Those skilled in the art should understand that the scope of the present disclosure involved in the embodiments of the present disclosure is not limited to the technical solutions formed by specific combinations of the foregoing technical features, and shall also cover other technical solutions formed by any combination of the foregoing technical features or equivalent features thereof without departing from the foregoing inventive concept. For example, a technical solution formed by a replacement of the foregoing features with technical features with similar functions in the technical features disclosed in the embodiments of the present disclosure (but not limited thereto) also falls within the scope of the present disclosure.

## Claims

1. A method for controlling at least one power converter, the method comprising:
generating at least one electrochemical impedance spectra (EIS) reference signal, the at least one EIS reference signal each having a frequency selected for EIS;
superimposing the at least one EIS reference signal respectively on at least one control reference signal to produce at least one superimposed reference signal;
controlling the at least one power converter respectively based on the at least one superimposed reference signal to cause respectively charging/discharging at least one battery module;
acquiring at least one response signal produced respectively by the at least one battery module; and
calculating at least one EIS respectively for the at least one battery module respectively based on the at least one superimposed reference signal and the at least one response signal.

2. The method according to claim 1, wherein
the at least one battery module each comprises at least one battery cell connected in series, and
the at least one response signal each comprises a voltage signal generated across respective ones of the at least one battery cell;
wherein:
the charge/discharge of the battery module based on the superimposed reference signal comprises controlling a charging/discharging current.

3. The method according to claim 1, wherein
the at least one battery module each comprises at least one battery string connected in parallel, wherein each battery string includes at least one battery cell, and
the at least one response signal each comprises a current signal output from a respective one of the at least one battery string;
wherein:
the charge/discharge of the battery module based on the superimposed reference signal comprises controlling a charging/discharging voltage across the at least one battery string.

4. The method according to any one of claims 1 to 3, wherein
the generation of the at least one EIS reference signal comprises pulse-width modulating the EIS reference signal.

5. The method according to any one of claims 1 to 3, wherein the number of the at least one battery module is an integral multiple of two, and the EIS reference signals for every two power converters are spaced with a phase shift of 180 degrees.

6. The method according to any one of claims 1 to 3, wherein the number of the at least one battery module is N that is an odd number being above two, and the corresponding EIS reference signals are spaced with a phase shift of 360 degrees divided by N.

7. The method according to any one of claims 1 to 3, further comprising deriving status information about a health condition of the respective ones of the at least one battery module using respective ones of the at least one calculated EIS.

8. The method according to any one of claims 1 to 3,
wherein the acquiring the at least one response signal is performed by a battery management system (BMS).

9. The method according to any one of claims 1 to 3, wherein the at least one power converter each comprises a power electronic component comprising silicon carbide.

10. The method according to any one of claims 1 to 3, wherein the at least one control reference signal includes an inertia reference signal, a fast frequency support reference signal, a frequency control ancillary service reference signal, a network support reference signal, and/or a charging/discharging reference signal.

11. An apparatus for controlling at least one power converter, the apparatus comprising means for performing the method of any one of claims 1-10.

12. A computer readable storage medium comprising instructions which, when executed by a processor, cause the processor to perform the method of any one of claims 1-10.

13. A system for controlling at least one power converter, comprising:
the at least one power converter;
at least one battery module; and
a controlling apparatus comprising means for performing the method of any one of claims 1-10.
